# EUROPÄISCHE PATENTANMELDUNG

(11) **EP 2 234 166 A1**
(43) Veröffentlichungstag der Anmeldung: **29.09.2010**
(21) Anmeldenummer: 09004432.2
(22) Anmeldetag: 27.03.2009
(51) Int. Cl.: H01L 31/0224, H01L 31/18

(54) **Verfahren zur Herstellung einer Solarzelle und Solarzelle**

(71) Anmelder: KIOTO Photovoltaics GmbH, 9300 St. Veit (AT)
(72) Erfinder: Kröner, Friedrich, Dr., 9500 Villach (AT)
(74) Vertreter: Becker, Thomas

(57) **Zusammenfassung**

Die Erfindung betrifft ein Verfahren zur Herstellung einer Solarzelle sowie eine Solarzelle zur Gewinnung von elektrischem Strom, die auf einer ihrer Haupt-Oberflächen mindestens eine elektrische Leiterbahn aufweist.

## Beschreibung

Die Erfindung betrifft ein Verfahren zur Herstellung einer Solarzelle sowie eine Solarzelle zur Gewinnung von elektrischem Strom, die auf einer ihrer Haupt-Oberflächen mindestens eine elektrische Leiterbahn aufweist.

Bekannte Solarzellen weisen in der Regel folgende Leiterbahn-Struktur auf: Eine Vielzahl von schmalen und dünnen Leiterbahnen (sogenannte Finger) erstrecken sich parallel zueinander und senkrecht auf einen so genannten Busbar zu und sind mit diesem elektrisch verbunden. Mehrere solcher Busbars sind wiederum parallel zueinander auf einer Haupt-Oberfläche der Zelle angeordnet.

Eine solche Leiterbahn-Struktur auf einer Haupt-Oberfläche bildet eine Elektrode der Zelle. Die Gegenelektrode ist auf der anderen Haupt-Oberfläche angeordnet und in der Regel vollflächig ausgeführt.

Die beschriebene Leiterbahn-Struktur ist auf der Haupt-Oberfläche der Solarzelle angeordnet, die der Sonne zugewandt ist. Es handelt sich um die n-dotierte Oberfläche der Zelle.

Über Flachbänder, die an einem Ende mit den Busbars einer Zelle und am anderen Ende mit der Gegenelektrode einer weiteren Zelle verlötet sind, erfolgt eine Stromleitung der beispielsweise in Serie geschalteten Zellen innerhalb eines so genannten Strings, das ist eine serielle Verschaltung mehrerer Solarzellen.

Die elektrischen Leiterbahnen (einschließlich der Busbars) sollen auf der einen Seite so dünn und so schmal wie möglich ausgeführt werden, um möglichst wenig aktive Oberfläche der Solarzelle wegzunehmen. Die Leiterbahnen müssen andererseits aber auch so stabil und ausreichend dimensioniert sein, dass die gewünschte Stromleitung möglichst verlustfrei erfolgt. Hierzu gehört auch eine optimale Kontaktierung zwischen den Leiterbahnen und der Zellen-Oberfläche.

Eine weit verbreitete Methode zur Erzeugung von dünnen Leiterbahnen und Elektroden-Strukturen auf gattungsgemäßen Zellen ist die Dickfilmmetallisierung. Ausgangsmaterial für die Erzeugung der Leiterbahnen sind druckfähige Pasten, die elektrisch leitende Metallpartikel und oxidische Komponenten enthalten. Sie können durch Siebdruck oder Tampondruck aufgebracht werden. Mit den Siebdruck-Verfahren lassen sich Leiterbahnen bis ca. 100 µm Breite erzeugen. Nachteilig ist, dass sich der elektrische Widerstand deutlich erhöht, wenn die Leiterbahnen schmaler werden. Schmale Leiterbahnen sind jedoch vorteilhaft.

Aus der EP 0 542 148 B1 ist ein Verfahren zur Erzeugung einer Leiterbahn-Struktur bekannt, wobei eine Paste aufgebracht wird, die Silberpartikel enthält. Die Paste wird eingebrannt. Die Struktur wird anschließend bei Raumtemperatur in einem neutralen Metallisierungsbad galvanisch verstärkt, wobei auch dieses Metallisierungsbad Silberionen enthält.

Mit diesem 2-stufigen Verfahren lässt sich zwar eine Reduzierung des elektrischen Widerstandes im Vergleich zur klassischen Siebdrucktechnik erreichen. Ein wesentlicher Nachteil besteht jedoch darin, dass die Leiterbahnen eine unregelmäßige Form aufweisen, insbesondere die Außenkanten eine sehr unregelmäßige Struktur aufweisen, ähnlich einem Fransenteppich. Darüber hinaus führt das Einbrennen der Silberpaste nicht immer zu einem vollflächigen Kontakt der Leiterbahn mit der Zellenoberfläche.

Der Erfindung liegt deshalb die Aufgabe zugrunde, eine Solarzelle der genannten Art anzubieten, die die Ausbildung möglichst dünner Leiterbahnen in beliebigem Abstand zueinander erlaubt, wobei die Leiterbahnen in einem einfachen Verfahren herstellbar sind und einen möglichst geringen elektrischen Widerstand aufweisen.

Grundgedanke der Erfindung ist es, die Leiterbahn(en) durch einen elektrochemischen Prozess auf die Zellenoberfläche aufzubringen. Dabei dient eine Schablone dazu, die Oberflächenbereiche der Zelle abzudecken, die frei von Leiterbahnen bleiben sollen, oder anders ausgedrückt: die Schablone weist dort Ausnehmungen (Schlitze) auf, wo die Leiterbahnen ausgebildet werden sollen. Diese Schlitze können extrem schmal sein, was Breiten von deutlich unter 1,0 mm bedeutet, bei quasi beliebiger Länge (lediglich begrenzt durch die Größe der Zelle). Der Begriff "Schablone" inkludiert einen selbstständigen Körper, zum Beispiel aus Kautschuk, der auf die Solarzelle (den Wafer) temporär aufgelegt wird, aber auch dauerhaft auf der Hauptoberfläche aufgebrachte Beschichtungen mit entsprechenden Ausnehmungen an den Stellen, an denen die Leiterbahnen erstellt werden sollen.

Der weitere Erfindungsgedanke besteht darin, die Leiterbahn zweischichtig auszubilden, wobei die erste Schicht einen Haftvermittler zwischen Zellen-Oberfläche und der zweiten Schicht bildet. Dieser Gedanke wird dadurch ergänzt, dass die Schichten in einem elektrochemischen Verfahren aufgetragen werden. Diese Technik ist einfach auszuführen und ermöglicht es, die erste Schicht (den Haftvermittler) nahezu vollflächig mit der Zellenoberfläche zu verbinden und in einem zweiten Schritt, wiederum innerhalb eines galvanischen Bades, eine elektrisch leitende zweite Schicht der Leiterbahn auf der ersten Schicht (dem Haftvermittler) abzuscheiden, was aufgrund der gewählten Galvanik wiederum zu einem nahezu 100 %-igen Kontaktbereich zwischen erster und zweiter Schicht führt.

Ein weiterer Gesichtspunkt kommt hinzu: Durch die Geometrie der Schlitze in der Schablone lässt sich eine korrespondierende exakte Geometrie der Leiterbahn erreichen. Die seitlichen Kanten der Leiterbahn fransen nicht mehr aus, wie bei der Siebdrucktechnik, sondern verlaufen (in technischem Sinne) nahezu 100 %-ig parallel zueinander beziehungsweise entsprechend der Geometrie der in der Schablone ausgesparten Abschnitte.

Danach betrifft die Erfindung in ihrer allgemeinsten Ausführungsform ein Verfahren zur Herstellung einer Solarzelle mit folgenden Schritten:
- eine erste Haupt-Oberfläche eines Solarzellen-Halbzeugs wird mit Ausnahme des oder der Abschnitte, entlang der die mindestens eine elektrische Leiterbahn ausgebildet werden soll, mit einer Schablone abgedeckt,
- eine zweite Haupt-Oberfläche des Solarzellen-Halbzeugs wird vollflächig abgedeckt,
- das Solarzellen-Halbzeug wird danach in ein erstes galvanisches Bad gegeben, bei dem das Solarzellen-Halbzeug als Anode geschaltet und eine Kathode angeordnet ist,
- das Solarzellen-Halbzeug bleibt solange in dem galvanischen Bad, bis sich ein Haftvermittler für ein nachfolgend aufzubringendes elektrisch leitendes Material aus dem galvanischen Bad als erste Schicht der elektrischen Leiterbahn auf dem oder den freiliegenden Abschnitt(en) des Solarzellen-Halbzeugs abgeschieden hat,
- nach einem Spülvorgang wird das Solarzellen-Halbzeug mit dem auf der ersten Haupt-Oberfläche abgeschiedenen Haftvermittler in ein zweites galvanisches Bad gegeben, bis sich das im galvanischen Bad gelöste elektrisch leitende Material als zweite Schicht der Leiterbahn auf dem oder den von dem Haftvermittler bedeckten Abschnitten abgeschieden hat, bevor
- die so gebildete Solarzelle anschließend gereinigt, getrocknet und getempert wird.

Die erfindungsgemäße Solarzelle umfasst grundsätzlich folgende Merkmale:
- mindestens eine mindestens zweischichtige elektrische Leiterbahn auf einer Haupt-Oberfläche,
- eine zweite, der Haupt-Oberfläche abgewandte Schicht weist eine Dicke von 5 bis 10µm aufweist und besteht aus einem elektrisch leitenden Material,
- eine erste, zwischen Haupt-Oberfläche und zweiter Schicht angeordnete Schicht bildet einen Haftvermittler zwischen der zweiten Schicht und der Haupt-Oberfläche,
- die erste Schicht weist eine Dicke von 1-5µm auf,
- die erste Schicht ist weitestgehend vollflächig mit der Hauptoberfläche verbunden,
- erste und zweite Schicht sind weitestgehend vollflächig miteinander verbunden.

Typischerweise ist die Schablone (beziehungsweise Abdeckung/Beschichtung) mit schlitzförmigen Ausnehmungen versehen, beispielsweise zwei im Abstand parallel zueinander verlaufenden Schlitzen, die später die so genannten Busbars bilden sowie einer Vielzahl von Schlitzen, die senkrecht zu diesen Busbar-Schlitzen verlaufen und mit einem Ende in die Schlitze für die Erstellung der Busbars einmünden. Bei dieser Anordnung verlaufen alle Schlitze entweder parallel oder senkrecht zueinander und es ergibt sich angenähert eine Kammstruktur.

Die Schlitze selbst können ebenfalls eine Rechteckform (in der Aufsicht) aufweisen, wobei die Länge ein Vielfaches der Breite ist. Typischerweise beträgt die Dimensionierung eines Schlitzes, entlang dem später ein Busbar erstellt werden soll, größenordnungsmäßig: Länge: 7 bis 20 cm, Breite: 0,05-1,0mm, insbesondere 0,1-0,4mm. Für die senkrecht dazu verlaufenden Schlitze gelten beispielsweise folgende Dimensionierungen: Länge: 3 bis 7 cm, Breite: 0,05 bis 0,5 mm, insbesondere 0,1-0,3mm.

Für die Solarzelle ergibt sich ein rechteckiger Leiterbahnquerschnitt, wobei die erste Schicht (in Kontakt mit der Zellen-Oberfläche) aus einer Nickellegierung bestehen kann und die zweite Schicht (die die erste Schicht außenseitig bedeckt) beispielsweise eine Schicht ist, die überwiegend aus Kupfer besteht. Für die Dimensionierung der Leiterbahnen gelten die Angaben zu den Schlitzen in der Schablone entsprechend.

Die Dicke der Schablone spielt keine entscheidende Rolle. Sie muss lediglich mindestens so dick sein wie die auszubildende Leiterbahn.

Die Dicke der Leiterbahn beträgt in der Regel bis zu 20µm.

Je präziser die Schablone gearbeitet ist, das heißt je präziser die Geometrie der Schlitze ist, umso präziser wird die Geometrie der entsprechend ausgebildeten Leiterbahnen. Bei einer Matrize aus Kautschuk lassen sich aus technischer Sicht exakt glatte Schlitzwände erstellen, so dass auch die entlang dieser Schlitze ausgebildeten Leiterbahnen praktisch eine konstante Breite über ihre gesamte Länge aufweisen. Die Längsseiten verlaufen mehr oder weniger ideal parallel zueinander. Dies gilt auch für die Höhe (Dicke) der entsprechenden Leiterbahn. Aufgrund der galvanischen Abscheidung entsteht eine gleichmäßige Dicke über die Breite der Leiterbahn.

Im Ergebnis stehen nahezu ideale Leiterbahn-Geometrien zur Verfügung, insbesondere solche mit Rechteck-Querschnitt, die folgende Vorteile kumulativ erfüllen:
- Es wird so wenig Platz wie notwendig auf der Zellenoberfläche in Anspruch genommen,
- der elektrische Widerstand ist so gering wie möglich,
- der Stromfluss ist aufgrund der konstanten Geometrie der Leiterbahnen über ihre gesamte Länge optimiert,
- die Leiterbahn haftet zu annähernd 100 % auf der Zellen-Oberfläche.

Soweit von einer vollflächigen Verbindung zwischen der ersten Schicht und der Zellenoberfläche oder der zweiten Schicht mit der ersten Schicht gesprochen wird, wird hierunter eine Verbindung verstanden, die mindestens 90 %, oft > 98 % der theoretisch möglichen Verbindungsfläche umfasst.

Die elektrochemischen Verfahrensschritte arbeiten üblicherweise mit einer Spannung zwischen 2 und 20 Volt bei einem Stromfluss zwischen 0,5 und 5 A/dm².

Der Spülvorgang zwischen den Galvanik-Schritten dient dazu, überschüssigen Elektrolyt aus dem ersten Schritt abzuspülen, insbesondere von der Oberfläche der Schablone. Das Spülmittel kann beispielsweise Wasser sein.

Dies gilt auch für die Reinigung der Solarzelle nach dem zweiten Galvanik-Schritt. Die Trocknung erfolgt beispielsweise durch warme Luft.

Während der anschließenden Temperung, die insbesondere Temperaturen bis 700°C, insbesondere 200-400°C umfasst, erfolgt eine Stabilisierung und Aushärtung der zuvor galvanisch aufgebrachten Schichten. Diese Temperung kann in einem Ofen erfolgen und dauert üblicherweise wenige Minuten bei den genannten Temperaturen. Vor diesem Temperaturschritt wird die Schablone entfernt.

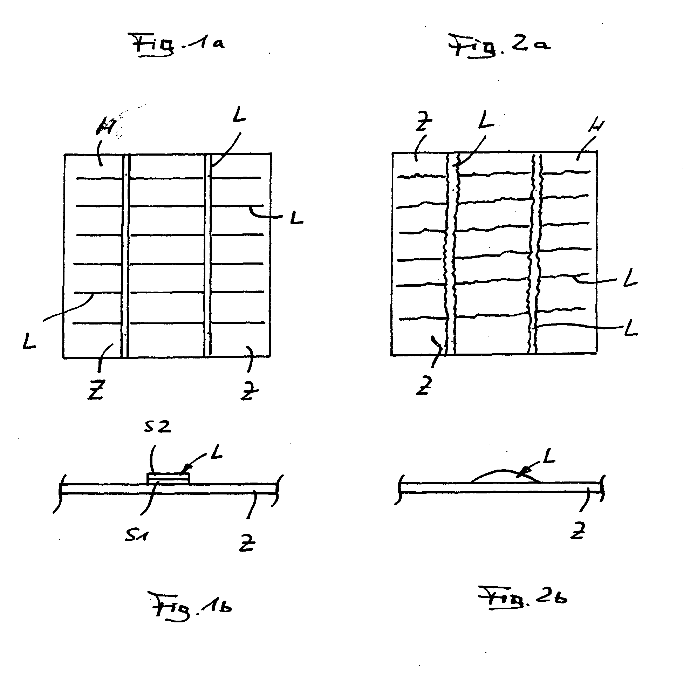

Der Anmeldung ist eine Skizze angeschlossen, die in Figur 1 eine erfindungsgemäße Leiterbahn-Struktur und in Figur 2 eine mittels Siebdruck aufgebrachte Leiterbahn-Struktur (Stand der Technik) beschreibt.

Zu erkennen ist, dass die erfindungsgemäße Leiterbahn-Struktur sich dadurch auszeichnet, dass die einzelnen Leiterbahnen auf der n-dotierten Haupt-Oberfläche (H) ("Sonnenseite") der Zelle geradlinig verlaufen (Fig.1a) und parallel zueinander verlaufende Außenkanten aufweisen, während sich beim Siebdruck-Verfahren eine unspezifische Linienform ergibt (Fig. 2a) und die gegenüber liegenden Abschnitte jeder Leiterbahn ausgefranst sind.

Die darunter angeordneten Schnittdarstellungen (Fig. 1b, 2b) durch eine Leiterbahn L auf einer Zelle Z zeigen, dass die erfindungsgemäße Leiterbahn (Fig. 1b) faktisch einen ideal rechteckigen Querschnitt aufweist, während die mittels Siebdruck aufgebrachte Leiterbahn (Fig. 2b) im Schnitt "hügelartig" ist. Dies hat den Nachteil, dass im Kontaktbereich zur Zelle relativ viel Fläche in Anspruch genommen wird, durch die Querschnittsverjüngung im frei liegenden Oberflächenbereich aber der für den Stromfluss wirksame Querschnitt deutlich verringert ist. Oder anders ausgedrückt: bei gleicher Querschnittsfläche benötigt eine erfindungsgemäß aufgebrachte Leiterbahn eine deutlich geringere Kontaktfläche zur Zelle.

Die weiteren Maße der Leiterbahn gemäß Fig. 1b sind:
Breite: 0,3mm
Höhe der ersten Schicht S1 (Haftvermittler auf Nickelbasis): 3µm Höhe der zweiten Schicht S2 (auf Kupferbasis): 8µm

## Patentansprüche

1. Verfahren zur Herstellung einer Solarzelle mit folgenden Schritten:
1.1eine erste Haupt-Oberfläche eines Solarzellen-Halbzeugs wird mit Ausnahme des oder der Abschnitte, entlang der die mindestens eine elektrische Leiterbahn ausgebildet werden soll, mit einer Schablone abgedeckt,
1.2eine zweite Haupt-Oberfläche des Solarzellen-Halbzeugs wird vollflächig abgedeckt,
1.3das Solarzellen-Halbzeug wird danach in ein erstes galvanisches Bad gegeben, bei dem das Solarzellen-Halbzeug als Anode geschaltet und eine Kathode angeordnet ist,
1.4das Solarzellen-Halbzeug bleibt solange in dem galvanischen Bad, bis sich ein Haftvermittler für ein nachfolgend aufzubringendes elektrisch leitendes Material aus dem galvanischen Bad als erste Schicht der elektrischen Leiterbahn auf dem oder den freiliegenden Abschnitt(en) des Solarzellen-Halbzeugs abgeschieden hat,
1.5nach einem Spülvorgang wird das Solarzellen-Halbzeug mit dem auf der ersten Haupt-Oberfläche abgeschiedenen Haftvermittler in ein zweites galvanisches Bad gegeben, bis sich das im galvanischen Bad gelöste elektrisch leitende Material als zweite Schicht der Leiterbahn auf dem oder den von dem Haftvermittler bedeckten Abschnitten abgeschieden hat, bevor
1.6die so gebildete Solarzelle anschließend gereinigt, getrocknet und getempert wird.

2. Verfahren nach Anspruch 1, bei dem eine Schablone verwendet wird, deren Materialstärke mindestens der Dicke der auszubildenden Leiterbahn entspricht.

3. Verfahren nach Anspruch 1, bei dem eine Schablone mit mindestens einer schlitzförmigen Aussparung verwendet wird, wobei ein oder mehrere Ränder der Aussparung in der Montageposition der Schablone auf dem Solarzellen-Halbzeug weitestgehend senkrecht zur korrespondierenden Haupt-Oberfläche der Solarzelle verlaufen.

4. Verfahren nach Anspruch 1, bei dem die Abscheidung des Haftvermittlers im galvanischen Bad so erfolgt, dass die Schichtdicke nach dem Temperschritt 1 bis 5 µm beträgt.

5. Verfahren nach Anspruch 1, bei dem die Abscheidung des elektrisch leitenden Materials im galvanischen Bad so erfolgt, dass die Schichtdicke nach dem Temperschritt 5-10µm beträgt.

6. Solarzelle mit folgenden Merkmalen:
6.1mindestens einer mindestens zweischichtigen elektrischen Leiterbahn (L) auf einer Haupt-Oberfläche (H),
6.2eine zweite, der Haupt-Oberfläche (H) abgewandte Schicht (S2) weist eine Dicke von 5 bis 10µm aufweist und besteht aus einem elektrisch leitenden Material,
6.3eine erste, zwischen Haupt-Oberfläche (H) und zweiter Schicht (52) angeordnete Schicht (S1) bildet einen Haftvermittler zwischen der zweiten Schicht (S2) und der Haupt-Oberfläche (H),
6.4die erste Schicht (S1) weist eine Dicke von 1-5µm auf,
6.5die erste Schicht (S1) ist weitestgehend vollflächig mit der Hauptoberfläche verbunden,
6.6erste und zweite Schicht (S1, S2) sind weitestgehend vollflächig miteinander verbunden.

7. Solarzelle nach Anspruch 6, deren mindestens eine Leiterbahn (L)in einem Schnitt, senkrecht zur korrespondierenden Haupt-Oberfläche (H), ein Rechteckprofil aufweist.

8. Solarzelle nach Anspruch 6, deren Leiterbahn(en) (L) eine erste Schicht (S1) auf Basis von Nickel aufweist/aufweisen.

9. Solarzelle nach Anspruch 6, deren Leiterbahn(en) (L) eine zweite Schicht (S2) auf Basis von Kupfer aufweist/aufweisen.

10. Solarzelle nach Anspruch 6, deren Leiterbahn(en) (L) eine Breite zwischen 0,05 und 0,4mm aufweist/aufweisen.
